# EUROPEAN PATENT SPECIFICATION

(11) **EP 4 350 374 B1**
(45) Date of publication and mention of the grant of the patent: **08.04.2026**
(21) Application number: 22904582.8
(22) Date of filing: 02.12.2022
(51) Int. Cl.: G01R 31/392, G01R 31/367, G01R 31/378, G01R 31/382

(54) **BATTERY STATE ESTIMATING APPARATUS AND METHOD**
VORRICHTUNG UND VERFAHREN ZUR SCHÄTZUNG DES BATTERIEZUSTANDS
APPAREIL ET PROCÉDÉ D'ESTIMATION D'ÉTAT DE BATTERIE

(30) Priority: 06.12.2021 KR 20210173264
(43) Date of publication of application: 10.04.2024
(73) Proprietor: LG Energy Solution, Ltd., Seoul 07335 (KR)
(72) Inventor: YUN, Kwi-Sub, Daejeon 34122 (KR); KIM, Hyoung-Kwon, Daejeon 34122 (KR); KIM, Min-Geun, Daejeon 34122 (KR); KIM, Su-Deok, Daejeon 34122 (KR); KIM, Jin-Soo, Daejeon 34122 (KR); LEE, Kwang-Soo, Daejeon 34122 (KR)
(74) Representative: Plasseraud IP
(86) International application number: PCT/KR2022/019527
(87) International publication number: WO 2023/106752

(56) References cited:
- EP-A1- 3 226 016
- WO-A1-2021/049882
- DE-A1- 102013 007 011
- KR-A- 20130 031 858
- KR-A- 20170 023 583
- KR-A- 20200 069 203
- US-A1- 2013 141 109
- US-A1- 2018 226 695
- US-A1- 2019 036 373
- US-A1- 2020 350 617

## Description

### TECHNICAL FIELD

The present disclosure relates to a battery state estimating apparatus and method, and more particularly, to a battery state estimating apparatus and method capable of determining whether lithium precipitation occurs in a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Although many studies are being conducted on the battery in terms of high capacity and high density, the aspect of improving lifespan and safety is also important. To this end, it is necessary to suppress the decomposition reaction with the electrolyte on the surface of the electrode, and to prevent overcharge and overdischarge.

In particular, it is necessary to prevent precipitation of lithium (lithium plating, Li-plating) on the surface of the negative electrode. When lithium precipitates on the surface of the negative electrode, it causes side reactions with the electrolyte and changes the kinetic balance of the battery, which may cause battery degradation. In addition, since an internal short circuit of the battery may occur as lithium metal precipitates on the surface of the negative electrode, there is a risk of ignition and explosion due to the internal short circuit. Therefore, it is necessary to develop a technology capable of detecting whether lithium metal is precipitated on the surface of the negative electrode.

EP3226016 A1, US2018/226695 A1, US2020/350617 A1, US2019/036373 A1 and DE 10 2013 007011 each relate to the detection of lithium precipitation in a battery during charging.

### DISCLOSURE

### Technical Problem

The present disclosure is designed to solve the problems of the related art, and therefore the present disclosure is directed to providing a battery state estimating apparatus and method that may quickly determine whether lithium precipitation occurs by checking an abnormal behavior of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery state estimating apparatus according to claim 1 is provided in one aspect of the present disclosure. An apparatus according to claim 3 is provided in a second aspect.

The control unit may be configured to judge that the abnormal behavior is confirmed when at least one of the voltage change rates calculated for each voltage of the battery is a negative number.

The control unit may be configured to block charging and discharging of the battery when it is determined that lithium is precipitated in the battery.

The control unit may be configured to judge whether an abnormal behavior occurs in the battery in the constant current charging process first, and judge whether an abnormal behavior occurs in the battery in the constant voltage charging process when an abnormal behavior of the battery is not confirmed in the constant current charging process.

A battery pack according to another aspect of the present disclosure may comprise the battery state estimating apparatus according to an aspect of the present disclosure.

A battery state estimating method according to claims 8 and 9 are provided in further aspects of the present disclosure.

### Advantageous Effects

According to one aspect of the present disclosure, there is an advantage in that whether lithium precipitation of the battery is judged in a non-destructive manner based on measurement information in the charging process of the battery, and the use of the battery can be appropriately controlled according to the judgment result.

In addition, according to one aspect of the present disclosure, there is an advantage in that whether lithium precipitation of the battery can be quickly judged only with measurement information obtained in the charging process of the battery.

The effects of the present disclosure are not limited to the above, and other effects not mentioned herein will be clearly understood by those skilled in the art from the appended claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery state estimating apparatus according to an embodiment of the present disclosure.
FIG. 2 is a diagram schematically showing a charging process of a battery.
FIG. 3 is a diagram schematically showing a charging process of a first battery according to an embodiment of the present disclosure.
FIG. 4 is a diagram schematically showing a charging process of a second battery according to an embodiment of the present disclosure.
FIG. 5 is a diagram schematically showing an exemplary configuration of a battery pack according to another embodiment of the present disclosure.
FIG. 6 is a diagram schematically showing a battery state estimating method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

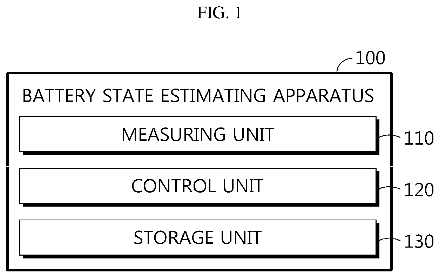

FIG. 1 is a diagram schematically showing a battery state estimating apparatus 100 according to an embodiment of the present disclosure.

Referring to FIG. 1, the battery state estimating apparatus 100 according to an embodiment of the present disclosure may include a measuring unit 110 and a control unit 120.

The measuring unit 110 may be configured to measure a charging current, and voltage and temperature of a battery in a constant current charging process and a constant voltage charging process of the battery.

Here, the battery refers to one physically separable independent cell having a negative electrode terminal and a positive electrode terminal. For example, a lithium-ion battery or a lithium polymer cell may be regarded as the battery. In addition, the battery may refer to a battery module in which a plurality of cells are connected in series and/or in parallel. Hereinafter, for convenience of description, the battery will be described as meaning one independent cell.

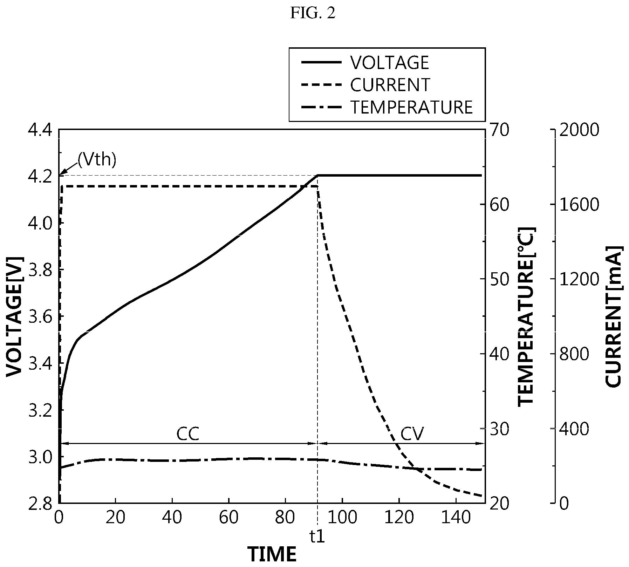

FIG. 2 is a diagram schematically showing a charging process of a battery.

Referring to FIG. 2, a typical battery charging process may include a constant current charging process and a constant voltage charging process.

The constant current charging process may be a process in which the battery is charged with a constant current until the voltage of the battery reaches a criterion value. For example, in the embodiment of FIG. 2, the battery may be charged with a constant current from time 0 to time t1. That is, from time 0 to time t1, the charging current is kept constant, and the voltage of the battery may be increased. In addition, at time t1, the voltage of the battery may reach the criterion value.

The constant voltage charging process may be a process in which the battery is charged with a constant voltage after the voltage of the battery reaches the criterion value. For example, in the embodiment of FIG. 2, the battery may be charged with a constant voltage from time t1 onwards. That is, from the time t1 onwards, the voltage of the battery is kept constant, and the charging current may be decreased. The constant voltage charging may be terminated when the decreasing charging current reaches a preset cutoff value.

The measuring unit 110 may be communicatively connected to the control unit 120. In addition, the measuring unit 110 may transmit measurement information including the measured charging current, battery voltage, and battery temperature to the control unit 120.

The control unit 120 may be configured to judge whether an abnormal behavior occurs in the battery according to the behavior of at least one of the charging current, battery voltage, and battery temperature in at least one of the constant current charging process and the constant voltage charging process.

Here, the abnormal behavior may mean a specific behavior of the charging current and/or the battery voltage and/or the battery temperature that does not appear in a constant current charging process and a constant voltage charging process of a normal battery.

For example, the embodiment of FIG. 2 shows the charging current, battery voltage, and battery temperature in a constant current charging process and a constant voltage charging process of a normal battery. The control unit 120 may judge that an abnormal behavior occurs in the battery when the behavior of at least one of charging current, battery voltage, and battery temperature is different from that of the embodiment of FIG. 2. Details of how the control unit 120 judges the abnormal behavior of the battery in each of the constant current charging process and the constant voltage charging process will be described later.

The control unit 120 may be configured to determine whether lithium precipitation occurs in the battery based on the judged abnormal behavior of the battery.

Specifically, when the abnormal behavior of the battery is confirmed, the control unit 120 may judge that lithium metal is precipitated in the corresponding battery. More specifically, the control unit 120 may judge that lithium metal is precipitated on the surface of the negative electrode of the corresponding battery.

In general, since an internal short circuit of the battery may occur as lithium metal is precipitated on the surface of the negative electrode, there is a risk of ignition and explosion due to the internal short circuit. Accordingly, the control unit 120 may be configured to block charging and discharging of the battery when it is determined that lithium is precipitated in the battery.

That is, the control unit 120 may judge whether lithium precipitation occurs according to the abnormal behavior of the battery in the constant current charging process and the constant voltage charging process of the battery, and block the use of the battery when it is judged that lithium is precipitated.

The battery state estimating apparatus 100 according to an embodiment of the present disclosure may judge whether lithium precipitation occurs in a battery in a non-destructive manner based on measurement information in the charging process of the battery and control the use of the battery.

In addition, since the battery state estimating apparatus 100 judges whether lithium precipitation occurs in the battery based on the measurement information obtained in the charging process, there is an advantage in that measurement information obtained in multiple charging processes for the battery is not required to judge whether lithium is precipitated. That is, the battery state estimating apparatus 100 has an advantage of quickly judging whether lithium precipitation occurs in a battery only with the measurement information obtained in one charging cycle.

In addition, since the battery state estimating apparatus 100 can judge whether lithium precipitation occurs in the battery by analyze the measurement information obtained in one charging cycle, machine learning techniques for big data processing are not required. Therefore, the battery state estimating apparatus 100 has an advantage of judging lithium precipitation of the battery even with a small amount of system resources.

Meanwhile, the control unit 120 included in the battery state estimating apparatus 100 may optionally include an application-specific integrated circuit (ASIC), another chipset, a logic circuit, a register, a communication modem, and a data processing device, and the like, known in the art to execute various control logics disclosed below. Also, when the control logic is implemented as software, the control unit 120 may be implemented as a set of program modules. At this time, the program modules may be stored in a memory and executed by the control unit 120. The memory may be internal or external to the control unit 120 and may be connected to the control unit 120 by various well-known means.

In addition, the battery state estimating apparatus 100 may further include a storage unit 130. The storage unit 130 may store data necessary for operation and function of each component of the battery state estimating apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

The control unit 120 may be configured to determine that lithium is precipitated in the battery when an abnormal behavior of the battery is confirmed in any one of the constant current charging process and the constant voltage charging process.

For example, the control unit 120 may determine that lithium is precipitated in the battery when an abnormal behavior of the battery is confirmed in the constant current charging process and/or the constant voltage charging process.

Preferably, the control unit 120 may be configured to judge whether an abnormal behavior occurs in the battery in the constant current charging process first, and judge whether an abnormal behavior occurs in the battery in the constant voltage charging process if the abnormal behavior of the battery is not confirmed in the constant current charging process.

Referring to FIG. 2, in charging the battery, the constant current charging process may be performed first, followed by the constant voltage charging process. Therefore, the control unit 120 may judge whether an abnormal behavior occurs in the battery in the constant current charging process first according to the charging time of the battery based on the measurement information received from the measuring unit 110, and then judge whether an abnormal behavior occurs in the battery in the constant voltage charging process.

Hereinafter, an embodiment in which the control unit 120 judges an abnormal behavior of a battery in the constant current charging process will be described.

The control unit 120 may be configured to calculate a voltage change rate over time for each voltage of the battery measured by the measuring unit 110 in the constant current charging process.

Here, the voltage change rate may be an instantaneous change rate of voltage over time. For example, if voltage is expressed as V and time is expressed as t, the voltage change rate may be expressed as dV/dt.

The control unit 120 may be configured to judge that the abnormal behavior is confirmed when the calculated voltage change rate is less than a criterion voltage change rate.

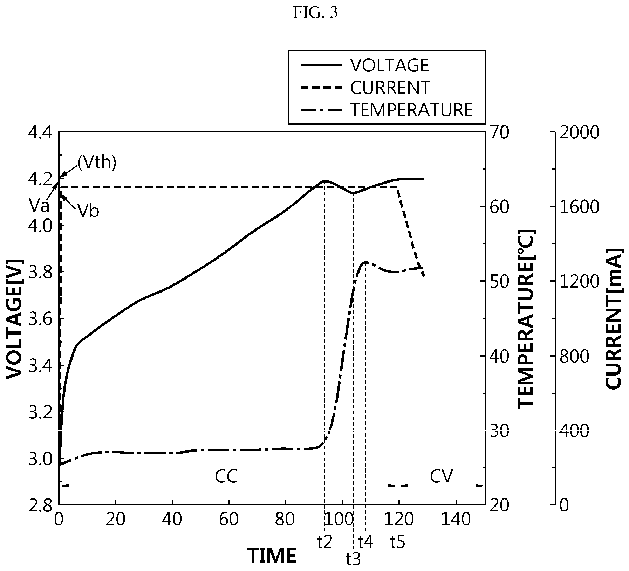

FIG. 3 is a diagram schematically showing a charging process of a first battery according to an embodiment of the present disclosure. Here, the first battery may be a battery in which lithium metal is precipitated on the surface of the negative electrode.

In the embodiment of FIG. 3, the first battery may be charged with a constant current from time 0 to time t5 and charged with a constant voltage from time t5 onwards. At time t2, the voltage of the battery may increase to Va, and at time t3, the battery voltage may decrease to Vb. After time t3, the voltage of the battery may increase again and reach the criterion value at time t5. That is, the constant current charging process may be performed from time 0 to time t5, and the constant voltage charging process may be performed after time t5.

Referring to FIG. 2, in a normal constant current charging process of a battery, there is no change in charging current, and the voltage may be continuously increased. That is, in the constant current charging process of a normal battery, the voltage change rate may always be greater than or equal to the criterion voltage change rate. For example, the criterion voltage change rate may be 0 (V/s).

On the other hand, referring to FIG. 3, in the first battery, a section in which the voltage change rate is less than the criterion voltage change rate may appear in the constant current charging process. During the time t2 to t3, the voltage change rate may be less than the criterion voltage change rate. That is, the control unit 120 may be configured to judge that an abnormal behavior is confirmed when at least one of the voltage change rates calculated for each voltage of the battery is a negative number.

As in the embodiment of FIG. 3, when a section in which the voltage change rate is less than the criterion voltage change rate appears in the constant current charging process, since the state of the first battery is not a normal state, the control unit 120 may confirm the abnormal behavior of the first battery based on the voltage change rate in the constant current charging process. In addition, when the abnormal behavior of the first battery is confirmed, the control unit 120 may judge that lithium metal is precipitated in the first battery and block charging and discharging of the first battery.

More specifically, the control unit 120 may be configured to calculate a temperature change rate over time for each temperature of the battery measured by the measuring unit 110 in the constant current charging process.

Here, the temperature change rate may be an instantaneous change rate of temperature over time. For example, if temperature is expressed as T and time is expressed as t, the temperature change rate may be expressed as dT/dt.

The control unit 120 may be configured to judge that an abnormal behavior is confirmed when the calculated temperature change rate is greater than or equal to the criterion temperature change rate for a predetermined period of time and the voltage change rate is less than the criterion voltage change rate.

The voltage of the battery measured by the measuring unit 110 may be a terminal voltage of the battery. The terminal voltage may be calculated according to Ohm's law (V = IR, where V is voltage, I is current, and R is resistance). When the temperature change rate of the battery is greater than or equal to the criterion temperature change rate for a predetermined period of time, the internal resistance of the battery may be reduced due to high temperature. That is, considering Ohm's law (V = IR), since the charging current is constant in the constant current charging process, the voltage of the battery measured by the measuring unit 110 may be decreased when the internal resistance of the battery is reduced.

In the embodiment of FIG. 3, it is assumed that the period from t2 to t4 is greater than or equal to a predetermined period, and the temperature change rate during the period from t2 to t4 is greater than or equal to the criterion temperature change rate. For example, the criterion temperature change rate is a temperature change rate that rises by 1°C per minute, and may be expressed as 1 (°C/minute). From time t2 to time t4, the temperature of the first battery may rise to the criterion temperature change rate or above. As the temperature of the first battery rises rapidly, the internal resistance of the first battery decreases, and as the internal resistance of the first battery decreases, the voltage of the first battery may decrease. That is, in the constant current charging process, as the temperature of the first battery rises rapidly, a section in which the voltage change rate of the first battery is less than the criterion voltage change rate may appear.

Accordingly, the control unit 120 may judge an abnormal behavior of the battery by considering both the temperature change rate and the voltage change rate of the battery. In addition, the control unit 120 may estimate that lithium metal is precipitated in the battery when an abnormal behavior of the battery is confirmed.

The battery state estimating apparatus 100 according to an embodiment of the present disclosure has an advantage of quickly estimating whether lithium precipitation occurs in a battery based on measurement information obtained in the charging process of the battery. Therefore, since the battery state estimating apparatus 100 may quickly stop the operation of the battery in which lithium is precipitated, unexpected accidents such as fire or explosion may be prevented in advance.

Hereinafter, an embodiment in which the control unit 120 judges an abnormal behavior of a battery in the constant voltage charging process will be described.

The control unit 120 may be configured to calculate a current change rate over time for each charging current measured by the measuring unit 110 in the constant voltage charging process.

Here, the current change rate may be an instantaneous change rate of charging current over time. For example, if charging current is expressed as I and time is expressed as t, the current change rate may be expressed as dI/dt.

The control unit 120 may be configured to judge that an abnormal behavior is confirmed when the calculated current change rate exceeds the criterion current change rate.

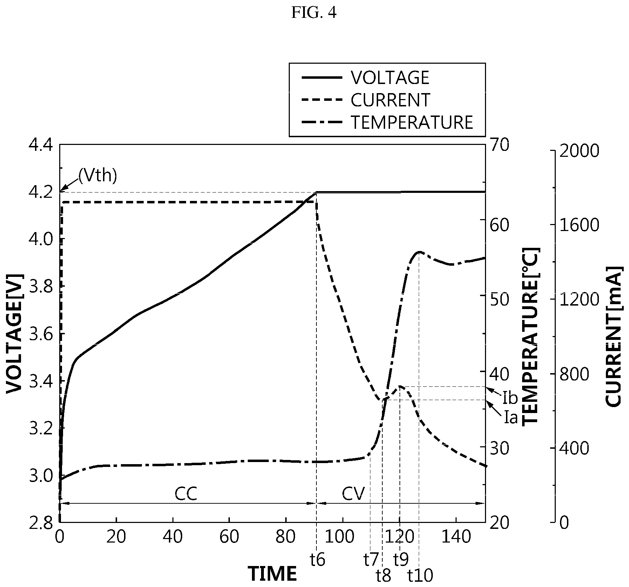

FIG. 4 is a diagram schematically showing a charging process of a second battery according to an embodiment of the present disclosure. Here, the second battery may be a battery in which lithium metal is precipitated on the surface of the negative electrode.

In the embodiment of FIG. 4, the second battery may be charged with a constant current from time 0 to time t6 and charged with a constant voltage from time t6 onwards. From time 0 to time t6, the charging current may be kept constant, and the voltage of the second battery may be increased. At time t6, the voltage of the second battery reaches the criterion value, and from time t6, the voltage of the second battery may be kept constant. During time t6 to time t8, the charging current may be decreased to Ia. In addition, the charging current may be increased from time t8, and the charging current may be increased up to Ib at time t9. After time t9, the charging current may be decreased again.

Referring to FIG. 2, in the constant voltage charging process of a normal battery, there is no change in the voltage of the battery, and the charging current may be continuously decreased. In addition, when the charging current reaches the cutoff value, charging of the battery may be terminated. That is, in the constant voltage charging process of a normal battery, the current change rate may always be less than or equal to the criterion current change rate. For example, the criterion current change rate may be 0 (mA/s).

On the other hand, referring to FIG. 4, in the second battery, a section in which the change rate of the charging current exceeds the criterion current change rate may appear in the constant voltage charging process. During times t8 to t9, the current change rate may exceed the criterion current change rate. That is, the control unit 120 may be configured to judge that an abnormal behavior is confirmed when at least one of the current change rates calculated for each charging current is a positive number.

As in the embodiment of FIG. 4, when a section in which the current change rate exceeds the criterion current change rate appears in the constant voltage charging process, since the state of the second battery is not a normal state, the control unit 120 may confirm an abnormal behavior of the second battery based on the current change rate in the constant voltage charging process. In addition, when the abnormal behavior of the second battery is confirmed, the control unit 120 may judge that lithium metal is precipitated in the second battery and block charging and discharging of the second battery.

More specifically, the control unit 120 may judge the abnormal behavior of the battery by further considering the temperature change rate in the constant voltage charging process. Here, since the temperature change rate has been described above, a redundant description thereof will be omitted.

The control unit 120 may be configured to calculate a temperature change rate over time for each temperature of the battery measured by the measuring unit 110 in the constant voltage charging process. In addition, the control unit 120 may be configured to judge that an abnormal behavior is confirmed when the calculated temperature change rate is greater than or equal to the criterion temperature change rate for a predetermined period and the current change rate exceeds the criterion current change rate.

When the temperature change rate of the battery is greater than or equal to the criterion temperature change rate for a predetermined period of time, the internal resistance of the battery may be reduced due to high temperature. That is, considering Ohm's law (V = IR), since the voltage of the battery is kept constant in the constant voltage charging process, the charging current measured by the measuring unit 110 may increase when the internal resistance of the battery decreases.

In the embodiment of FIG. 4, it is assumed that the period from t7 to t10 is greater than or equal to a predetermined period, and the temperature change rate during the period from t7 to t10 is greater than or equal to the criterion temperature change rate. For example, the criterion temperature change rate is a temperature change rate that rises by 1°C per minute, and may be expressed as 1 (°C/minute). From time t7 to time t10, the temperature of the second battery may rise to the criterion temperature change rate or above. As the temperature of the second battery rises rapidly, the internal resistance of the second battery decreases, and the charging current may decrease as the internal resistance of the second battery decreases. That is, in the constant voltage charging process, as the temperature of the second battery rises rapidly, a section in which the current change rate exceeds the criterion current change may appear.

Accordingly, the control unit 120 may judge the abnormal behavior of the battery by considering both the temperature change rate and the current change rate of the battery. In addition, the control unit 120 may estimate that lithium metal is precipitated in the battery when the abnormal behavior of the battery is confirmed.

The battery state estimating apparatus 100 according to an embodiment of the present disclosure has an advantage of quickly estimating whether lithium precipitation occurs in a battery based on measurement information obtained in the charging process of the battery. Therefore, since the battery state estimating apparatus 100 may quickly stop the operation of the battery in which lithium is precipitated, unexpected accidents such as fire or explosion may be prevented in advance.

The battery state estimating apparatus 100 according to the present disclosure may be applied to a battery management system (BMS). That is, the BMS according to the present disclosure may include the battery state estimating apparatus 100 described above. In this configuration, at least some of components of the battery state estimating apparatus 100 may be implemented by supplementing or adding functions of the components included in a conventional BMS. For example, the measuring unit 110, the control unit 120 and the storage unit 130 of the battery state estimating apparatus 100 may be implemented as components of the BMS.

In addition, the battery state estimating apparatus 100 according to the present disclosure may be provided to a battery pack. That is, the battery pack according to the present disclosure may include the above-described battery state estimating apparatus 100 and one or more battery cells. In addition, the battery pack may further include electrical components (a relay, a fuse and the like) and a case.

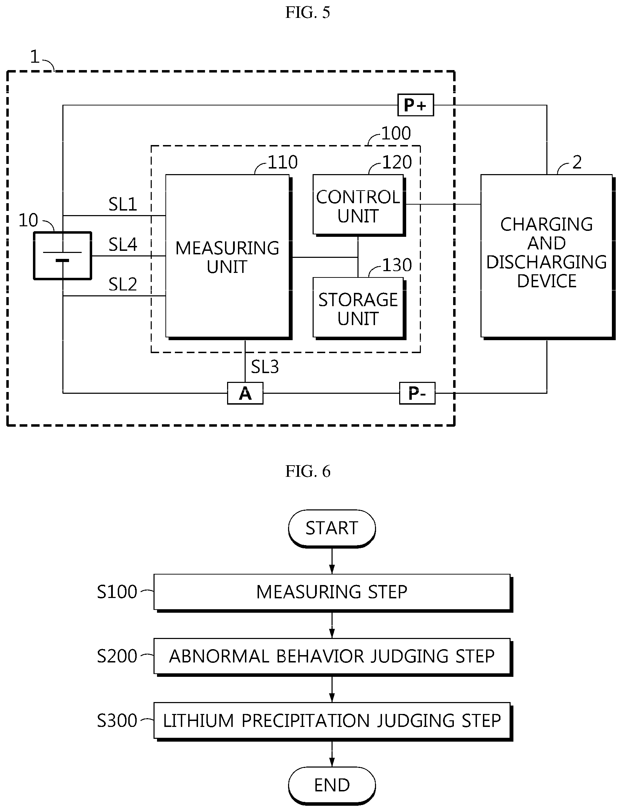

FIG. 5 is a diagram schematically showing an exemplary configuration of a battery pack according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 110 may be connected to the first sensing line SL1, the second sensing line SL2, the third sensing line SL3 and the fourth sensing line SL4. Specifically, the measuring unit 110 may be connected to the positive electrode terminal of the battery 10 through the first sensing line SL1, and may be connected to the negative electrode terminal of the battery 10 through the second sensing line SL2. The measuring unit 110 may measure the voltage of the battery 10 based on the voltage measured at each of the first sensing line SL1 and the second sensing line SL2.

In addition, the measuring unit 110 may be connected to the current measuring unit A through the third sensing line SL3. For example, the current measuring unit A may be an ammeter or a shunt resistor capable of measuring the charging current and the discharging current of the battery 10. The measuring unit 110 may measure the charging current of the battery 10 through the third sensing line SL3. Also, the measuring unit 110 may measure the discharging current of the battery 10 through the third sensing line SL3.

Also, the measuring unit 110 may measure the temperature of the battery 10 through the fourth sensing line SL4.

Preferably, the measuring unit 110 may measure the voltage, current, and temperature of the battery 10 at the same cycle.

The charging and discharging device 2 may have one end connected to the positive electrode terminal P+ of the battery pack 1 and the other end connected to the negative electrode terminal P- of the battery pack 1. Therefore, the positive electrode terminal of the battery 10, the positive electrode terminal P+ of the battery pack 1, the charging and discharging device 2, the negative electrode terminal P- of the battery pack 1, and the negative electrode terminal of the battery 10 may be electrically connected.

For example, the charging and discharging device 2 may be electrically connected to the positive electrode terminal P+ and the negative electrode terminal P- of the battery pack 1 to charge and/or discharge the battery 10.

FIG. 6 is a diagram schematically showing a battery state estimating method according to still another embodiment of the present disclosure.

Preferably, each step of the battery state estimating method may be performed by the battery state estimating apparatus 100. Hereinafter, for convenience of explanation, the content overlapping with the previously described content will be omitted or briefly described.

Referring to FIG. 6, the battery state estimating method may include a measuring step (S100), an abnormal behavior judging step (S200), and a lithium precipitation judging step (S300).

The measuring step (S100) is a step of measuring a charging current, and voltage and temperature of a battery in a constant current charging process and a constant voltage charging process of the battery, and may be performed by the measuring unit 110.

The abnormal behavior judging step (S200) is a step of judging whether an abnormal behavior occurs in the battery according to a behavior of at least one of the charging current, the battery voltage, and the battery temperature in at least one of the constant current charging process and the constant voltage charging process, and may be performed by the control unit 120.

The control unit 120 may judge whether an abnormal behavior occurs in the battery in the constant current charging process and/or the constant voltage charging process.

Specifically, in the constant current charging process, the control unit 120 may judge whether an abnormal behavior occurs in the battery based on the voltage and temperature of the battery. In addition, in the constant voltage charging process, the control unit 120 may judge whether an abnormal behavior occurs in the battery based on the charging current and the battery temperature. This is because the charging current is kept constant in the constant current charging process, and the voltage of the battery is kept constant in the constant voltage charging process.

The lithium precipitation judging step (S300) is a step for determining whether lithium precipitation occurs in the battery based on the abnormal behavior of the battery judged in the abnormal behavior judging step (S200), and may be performed by the control unit 120.

The control unit 120 may judge that lithium metal is precipitated in the battery when the abnormal behavior is confirmed in the battery in the abnormal behavior judging step (S200). Thereafter, the control unit 120 may block charging and discharging of the corresponding battery in order to stop the use of the corresponding battery. Therefore, since the use of the battery in which lithium metal is precipitated can be stopped immediately, unexpected accidents such as fire or explosion can be prevented in advance.

In addition, since the battery state estimating method may be directly applied in the charging process of the battery, whether lithium precipitation occurs in the battery may be quickly judged according to the measurement information in the charging process. Preferably, since whether lithium precipitation occurs in the battery can be judged in each charging process, accidents caused by the battery with lithium precipitation can be prevented in advance.

The embodiments of the present disclosure described above may not be implemented only through an apparatus and method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, the invention is defined by the appended claims.

### (Explanation of reference signs)

1: battery pack
2: charging and discharging device
10: battery
100: battery state estimating apparatus
110: measuring unit
120: control unit
130: storage unit

## Claims

1. A battery state estimating apparatus (100), comprising:
a measuring unit (110) configured to measure a charging current, and voltage and temperature of a battery in a constant current charging process and a constant voltage charging process of the battery; and
a control unit (120) configured to judge whether an abnormal behavior occurs in the battery according to a behavior of at least one of the charging current and the voltage of the battery and a behavior of the temperature of the battery in at least one of the constant current charging process and the constant voltage charging process, and determine whether lithium precipitation occurs in the battery based on the judged abnormal behavior of the battery,
wherein the control unit (120) is configured to:
calculate a voltage change rate over time for each voltage of the battery measured by the measuring unit in the constant current charging process,
calculate a temperature change rate over time for each temperature of the battery measured by the measuring unit in the constant current charging process, and
judge that the abnormal behavior is confirmed when the calculated temperature change rate is equal to or greater than a criterion temperature change rate for greater than or equal to a predetermined period of time and the voltage change rate is less than the criterion voltage change rate.

2. The battery state estimating apparatus (100) according to claim 1,
wherein the control unit (120) is configured to judge that the abnormal behavior is confirmed when at least one of the voltage change rates calculated for each voltage of the battery is a negative number.

3. A battery state estimating apparatus (100), comprising:
a measuring unit (110) configured to measure a charging current, and voltage and
temperature of a battery in a constant current charging process and a constant voltage charging process of the battery; and
a control unit (120) configured to judge whether an abnormal behavior occurs in the battery according to a behavior of at least one of the charging current and the voltage of the battery and a behavior of the temperature of the battery in at least one of the constant current charging process and the constant voltage charging process, and determine whether lithium precipitation occurs in the battery based on the judged abnormal behavior of the battery,
wherein the control unit (120) is configured to:
calculate a current change rate over time for each current of the battery measured by the measuring unit (110) in the constant voltage charging process,
calculate a temperature change rate over time for each temperature of the battery measured by the measuring unit in the constant voltage charging process, and
judge that the abnormal behavior is confirmed when the calculated temperature change rate is equal to or greater than the criterion temperature change rate for a predetermined period of time and the current change rate exceeds the criterion current change rate.

4. The battery state estimating apparatus (100) according to claim 3,
wherein the control unit (120) is configured to judge that the abnormal behavior is confirmed when at least one of the current change rates calculated for each current of the battery is a positive number.

5. The battery state estimating apparatus (100) according to claims 1 or 3,
wherein the control unit (120) is configured to block charging and discharging of the battery when it is determined that lithium is precipitated in the battery.

6. The battery state estimating apparatus (100) according to claims 1 or 3,
wherein the control unit (120) is configured to judge whether an abnormal behavior occurs in the battery in the constant current charging process first, and judge whether an abnormal behavior occurs in the battery in the constant voltage charging process when an abnormal behavior of the battery is not confirmed in the constant current charging process.

7. A battery pack (1), comprising the battery state estimating apparatus (100) according to any one of claims 1 to 6.

8. A battery state estimating method, comprising:
a measuring step (S100) of measuring a charging current, and voltage and temperature of a battery in a constant current charging process and a constant voltage charging process of the battery;
an abnormal behavior judging step (S200) of judging whether an abnormal behavior occurs in the battery according to a behavior of at least one of the charging current and the voltage of the battery and a behavior of the temperature of the battery in at least one of the constant current charging process and the constant voltage charging process; and
a lithium precipitation judging step (S300) of determining whether lithium precipitation occurs in the battery based on the abnormal behavior of the battery judged in the abnormal behavior judging step, wherein the abnormal behavior judging step (S200) comprises:
calculating a voltage change rate over time for each voltage of the battery measured in the constant current charging process,
calculating a temperature change rate over time for each temperature of the battery measured in the constant current charging process, and
judging that the abnormal behavior is confirmed when the calculated temperature change rate is equal to or greater than a criterion temperature change rate for greater than or equal to a predetermined period of time and the voltage change rate is less than the criterion voltage change rate.

9. A battery state estimating method, comprising:
a measuring step (S100) of measuring a charging current, and voltage and temperature of a battery in a constant current charging process and a constant voltage charging process of the battery;
an abnormal behavior judging step (S200) of judging whether an abnormal behavior occurs in the battery according to a behavior of at least one of the charging current and the voltage of the battery and a behavior of the temperature of the battery in at least one of the constant current charging process and the constant voltage charging process; and
a lithium precipitation judging step (S300) of determining whether lithium precipitation occurs in the battery based on the abnormal behavior of the battery judged in the abnormal behavior judging step, wherein the abnormal behavior judging step (S200) comprises:
calculating a current change rate over time for each current of the battery measured in the constant voltage charging process,
calculating a temperature change rate over time for each temperature of the battery measured in the constant voltage charging process, and
judging that the abnormal behavior is confirmed when the calculated temperature change rate is equal to or greater than the criterion temperature change rate for a predetermined period of time and the current change rate exceeds the criterion current change rate.

## Patentansprüche

1. Batteriestatusschätzvorrichtung (100), umfassend:
eine Messeinheit (110), welche dazu eingerichtet ist, einen Ladestrom sowie eine Spannung und eine Temperatur einer Batterie in einem Ladevorgang mit konstantem Strom und einem Ladevorgang mit konstanter Spannung der Batterie zu messen; und
eine Steuereinheit (120), welche dazu eingerichtet ist, gemäß einem Verhalten wenigstens eines aus dem Ladestrom und der Spannung der Batterie und einem Verhalten der Temperatur der Batterie in wenigstens einem aus dem Ladevorgang mit konstantem Strom und dem Ladevorgang mit konstanter Spannung zu beurteilen, ob in der Batterie ein abnormales Verhalten auftritt,
und auf Grundlage des beurteilten abnormalen Verhaltens der Batterie zu bestimmen, ob in der Batterie eine Lithiumausfällung auftritt,
wobei die Steuereinheit (120) eingerichtet ist zum:
Berechnen einer Spannungsänderungsrate über die Zeit für jede in dem Ladevorgang mit konstantem Strom durch die Messeinheit gemessene Spannung der Batterie,
Berechnen einer Temperaturänderungsrate über die Zeit für jede in dem Ladevorgang mit konstantem Strom durch die Messeinheit gemessene Temperatur der Batterie und
Beurteilen, dass das abnormale Verhalten bestätigt ist, wenn die berechnete Temperaturänderungsrate für einen Zeitraum, welcher größer als oder gleich wie ein vorbestimmter Zeitraum ist, gleich wie oder größer als eine Kriterium-Temperaturänderungsrate ist und die Spannungsänderungsrate kleiner als die Kriterium-Spannungsänderungsrate ist.

2. Batteriestatusschätzvorrichtung (100) nach Anspruch 1,
wobei die Steuereinheit (120) dazu eingerichtet ist, zu beurteilen, dass das abnormale Verhalten bestätigt ist, wenn wenigstens eine der für jede Spannung der Batterie berechneten Spannungsänderungsraten eine negative Zahl ist.

3. Batteriestatusschätzvorrichtung (100), umfassend:
eine Messeinheit (110), welche dazu eingerichtet ist, einen Ladestrom sowie eine Spannung und eine Temperatur einer Batterie in einem Ladevorgang mit konstantem Strom und einem Ladevorgang mit konstanter Spannung der Batterie zu messen; und
eine Steuereinheit (120), welche dazu eingerichtet ist, gemäß einem Verhalten wenigstens eines aus dem Ladestrom und der Spannung der Batterie und einem Verhalten der Temperatur der Batterie in wenigstens einem aus dem Ladevorgang mit konstantem Strom und dem Ladevorgang mit konstanter Spannung zu beurteilen, ob in der Batterie ein abnormales Verhalten auftritt,
und auf Grundlage des beurteilten abnormalen Verhaltens der Batterie zu bestimmen, ob in der Batterie eine Lithiumausfällung auftritt,
wobei die Steuereinheit (120) eingerichtet ist zum:
Berechnen einer Stromänderungsrate über die Zeit für jeden in dem Ladevorgang mit konstanter Spannung durch die Messeinheit (110) gemessenen Strom der Batterie,
Berechnen einer Temperaturänderungsrate über die Zeit für jede in dem Ladevorgang mit konstanter Spannung durch die Messeinheit gemessene Temperatur der Batterie und
Beurteilen, dass das abnormale Verhalten bestätigt ist, wenn die berechnete Temperaturänderungsrate für einen vorbestimmten Zeitraum gleich wie oder größer als die Kriterium-Temperaturänderungsrate ist und die Stromänderungsrate die Kriterium-Stromänderungsrate überschreitet.

4. Batteriestatusschätzvorrichtung (100) nach Anspruch 3,
wobei die Steuereinheit (120) dazu eingerichtet ist, zu beurteilen, dass das abnormale Verhalten bestätigt ist, wenn wenigstens eine der für jeden Strom der Batterie berechneten Stromänderungsraten eine positive Zahl ist.

5. Batteriestatusschätzvorrichtung (100) nach den Ansprüchen 1 oder 3,
wobei die Steuereinheit (120) dazu eingerichtet ist, ein Laden und ein Entladen der Batterie zu blockieren, wenn bestimmt ist, dass in der Batterie Lithium ausgefällt ist.

6. Batteriestatusschätzvorrichtung (100) nach den Ansprüchen 1 oder 3,
wobei die Steuereinheit (120) dazu eingerichtet ist, zunächst zu beurteilen, ob in dem Ladevorgang mit konstantem Strom in der Batterie ein abnormales Verhalten auftritt, und zu beurteilen, ob in dem Ladevorgang mit konstanter Spannung in der Batterie ein abnormales Verhalten auftritt, wenn in dem Ladevorgang mit konstantem Strom ein abnormales Verhalten der Batterie nicht bestätigt worden ist.

7. Batteriepack (1), umfassend die Batteriestatusschätzvorrichtung (100) nach einem der Ansprüche 1 bis 6.

8. Batteriestatusschätzverfahren, umfassend:
einen Messschritt (S100) eines Messens eines Ladestroms sowie einer Spannung und einer Temperatur einer Batterie in einem Ladevorgang mit konstantem Strom und einem Ladevorgang mit konstanter Spannung der Batterie;
einen Abnormales-Verhalten-Beurteilungsschritt (S200) eines Beurteilens, ob in der Batterie ein abnormales Verhalten auftritt, gemäß einem Verhalten wenigstens eines aus dem Ladestrom und der Spannung der Batterie und
einem Verhalten der Temperatur der Batterie in wenigstens einem aus dem Ladevorgang mit konstantem Strom und dem Ladevorgang mit konstanter Spannung; und
einen Lithiumausfällung-Beurteilungsschritt (S300) eines Bestimmens, ob in der Batterie eine Lithiumausfällung auftritt, auf Grundlage des in dem Abnormales-Verhalten-Beurteilungsschritt beurteilten abnormalen Verhaltens der Batterie,
wobei der Abnormales-Verhalten-Beurteilungsschritt (S200) umfasst:
Berechnen einer Spannungsänderungsrate über die Zeit für jede in dem Ladevorgang mit konstantem Strom gemessene Spannung der Batterie,
Berechnen einer Temperaturänderungsrate über die Zeit für jede in dem Ladevorgang mit konstantem Strom gemessene Temperatur der Batterie und Beurteilen, dass das abnormale Verhalten bestätigt ist, wenn die berechnete Temperaturänderungsrate für einen Zeitraum, welcher größer als oder gleich wie ein vorbestimmter Zeitraum ist, gleich wie oder größer als eine Kriterium-Temperaturänderungsrate ist und die Spannungsänderungsrate kleiner als die Kriterium-Spannungsänderungsrate ist.

9. Batteriestatusschätzverfahren, umfassend:
einen Messschritt (S100) eines Messens eines Ladestroms sowie einer Spannung und einer Temperatur einer Batterie in einem Ladevorgang mit konstantem Strom und einem Ladevorgang mit konstanter Spannung der Batterie;
einen Abnormales-Verhalten-Beurteilungsschritt (S200) eines Beurteilens, ob in der Batterie ein abnormales Verhalten auftritt, gemäß einem Verhalten wenigstens eines aus dem Ladestrom und der Spannung der Batterie und
einem Verhalten der Temperatur der Batterie in wenigstens einem aus dem Ladevorgang mit konstantem Strom und dem Ladevorgang mit konstanter Spannung; und
einen Lithiumausfällung-Beurteilungsschritt (S300) eines Bestimmens, ob in der Batterie eine Lithiumausfällung auftritt, auf Grundlage des in dem Abnormales-Verhalten-Beurteilungsschritt beurteilten abnormalen Verhaltens der Batterie,
wobei der Abnormales-Verhalten-Beurteilungsschritt (S200) umfasst:
Berechnen einer Stromänderungsrate über die Zeit für jeden in dem Ladevorgang mit konstanter Spannung gemessenen Strom der Batterie,
Berechnen einer Temperaturänderungsrate über die Zeit für jede in dem Ladevorgang mit konstanter Spannung gemessene Temperatur der Batterie und Beurteilen, dass das abnormale Verhalten bestätigt ist, wenn die berechnete Temperaturänderungsrate für einen vorbestimmten Zeitraum gleich wie oder größer als die Kriterium-Temperaturänderungsrate ist und die Stromänderungsrate die Kriterium-Stromänderungsrate überschreitet.

## Revendications

1. Appareil d'estimation d'état de batterie (100), comprenant :
une unité de mesure (110) configurée pour mesurer un courant de charge, et une tension et
la température d'une batterie dans un processus de charge à courant constant et un processus de charge à tension constante de la batterie ; et
une unité de contrôle (120) configurée pour juger si un comportement anormal a lieu dans la batterie selon un comportement d'au moins un parmi le courant de charge et la tension de la batterie et un comportement de la température de la batterie dans au moins un parmi le processus de charge à courant constant et le processus de charge à tension constante, et déterminer si une précipitation de lithium a lieu dans la batterie sur la base du comportement anormal jugé de la batterie, dans lequel l'unité de contrôle (120) est configurée pour :
calculer une vitesse de variation de tension au cours du temps pour chaque tension de la batterie mesurée par l'unité de mesure dans le processus de charge à courant constant,
calculer une vitesse de variation de température au cours du temps pour chaque température de la batterie mesurée par l'unité de mesure dans le processus de charge à courant constant, et
juger que le comportement anormal est confirmé lorsque la vitesse de variation de température calculée est égale ou supérieure à un critère de vitesse de variation de température pendant une durée supérieure ou égale à une durée prédéterminée et la vitesse de variation de tension est inférieure au critère de vitesse de variation de tension.

2. Appareil d'estimation d'état de batterie (100) selon la revendication 1,
dans lequel l'unité de contrôle (120) est configurée pour juger que le comportement anormal est confirmé lorsqu'au moins une parmi les vitesses de variation de tension calculées pour chaque tension de la batterie est un nombre négatif.

3. Appareil d'estimation d'état de batterie (100), comprenant :
une unité de mesure (110) configurée pour mesurer un courant de charge, et une tension et
la température d'une batterie dans un processus de charge à courant constant et un processus de charge à tension constante de la batterie ; et
une unité de contrôle (120) configurée pour juger si un comportement anormal a lieu dans la batterie selon un comportement d'au moins un parmi le courant de charge et la tension de la batterie et un comportement de la température de la batterie dans au moins un parmi le processus de charge à courant constant et le processus de charge à tension constante, et déterminer si une précipitation de lithium a lieu dans la batterie sur la base du comportement anormal jugé de la batterie,
dans lequel l'unité de contrôle (120) est configurée pour :
calculer une vitesse de variation de courant au cours du temps pour chaque courant de la batterie mesuré par l'unité de mesure (110) dans le processus de charge à tension constante,
calculer une vitesse de variation de température au cours du temps pour chaque température de la batterie mesurée par l'unité de mesure dans le processus de charge à tension constante, et
juger que le comportement anormal est confirmé lorsque la vitesse de variation de température calculée est égale ou supérieure au critère de vitesse de variation de température pendant une durée prédéterminée et la vitesse de variation de courant dépasse le critère de vitesse de variation de courant.

4. Appareil d'estimation d'état de batterie (100) selon la revendication 3,
dans lequel l'unité de contrôle (120) est configurée pour juger que le comportement anormal est confirmé lorsqu'au moins une parmi les vitesses de variation de courant calculées pour chaque courant de la batterie est un nombre positif.

5. Appareil d'estimation d'état de batterie (100) selon les revendications 1 ou 3,
dans lequel l'unité de contrôle (120) est configurée pour bloquer la charge et la décharge de la batterie lorsqu'il est déterminé que du lithium est précipité dans la batterie.

6. Appareil d'estimation d'état de batterie (100) selon les revendications 1 ou 3,
dans lequel l'unité de contrôle (120) est configurée pour juger si un comportement anormal a lieu dans la batterie dans le processus de charge à courant constant en premier, et juger si un comportement anormal a lieu dans la batterie dans le processus de charge à tension constante lorsqu'un comportement anormal de la batterie n'est pas confirmé dans le processus de charge à courant constant.

7. Bloc-batterie (1), comprenant l'appareil d'estimation d'état de batterie (100) selon l'une quelconque des revendications 1 à 6.

8. Procédé d'estimation d'état de batterie, comprenant :
une étape de mesure (S100) consistant à mesurer un courant de charge, et une tension et la température d'une batterie dans un processus de charge à courant constant et un processus de charge à tension constante de la batterie ;
une étape de jugement de comportement anormal (S200) consistant à juger si un comportement anormal a lieu dans la batterie selon un comportement d'au moins un parmi le courant de charge et la tension de la batterie et un comportement de la température de la batterie dans au moins un parmi le processus de charge à courant constant et le processus de charge à tension constante ; et
une étape de jugement de précipitation de lithium (S300) consistant à déterminer si une précipitation de lithium a lieu dans la batterie sur la base du comportement anormal de la batterie jugé à l'étape de jugement de comportement anormal, dans lequel l'étape de jugement de comportement anormal (S200) comprend : le calcul d'une vitesse de variation de tension au cours du temps pour chaque tension de la batterie mesurée dans le processus de charge à courant constant,
le calcul d'une vitesse de variation de température au cours du temps pour chaque température de la batterie mesurée dans le processus de charge à courant constant, et
le fait de juger que le comportement anormal est confirmé lorsque la vitesse de variation de température calculée est égale ou supérieure à un critère de vitesse de variation de température pendant une durée supérieure ou égale à une durée prédéterminée et la vitesse de variation de tension est inférieure au critère de vitesse de variation de tension.

9. Procédé d'estimation d'état de batterie, comprenant :
une étape de mesure (S100) consistant à mesurer un courant de charge, et une tension et la température d'une batterie dans un processus de charge à courant constant et un processus de charge à tension constante de la batterie ;
une étape de jugement de comportement anormal (S200) consistant à juger si un comportement anormal a lieu dans la batterie selon un comportement d'au moins un parmi le courant de charge et la tension de la batterie et un comportement de la température de la batterie dans au moins un parmi le processus de charge à courant constant et le processus de charge à tension constante ; et
une étape de jugement de précipitation de lithium (S300) consistant à déterminer si une précipitation de lithium a lieu dans la batterie sur la base du comportement anormal de la batterie jugé à l'étape de jugement de comportement anormal, dans lequel l'étape de jugement de comportement anormal (S200) comprend :
le calcul d'une vitesse de variation de courant au cours du temps pour chaque courant de la batterie mesuré dans le processus de charge à tension constante,
le calcul d'une vitesse de variation de température au cours du temps pour chaque température de la batterie mesurée dans le processus de charge à tension constante, et
le fait de juger que le comportement anormal est confirmé lorsque la vitesse de variation de température calculée est égale ou supérieure au critère de vitesse de variation de température pendant une durée prédéterminée et la vitesse de variation de courant dépasse le critère de vitesse de variation de courant.
